# EUROPEAN PATENT SPECIFICATION

(11) **EP 1 573 803 B1**
(45) Date of publication and mention of the grant of the patent: **05.06.2013**
(21) Application number: 03814832.6
(22) Date of filing: 15.12.2003
(51) Int. Cl.: H01L 21/8238

(54) **INTEGRATING N-TYPE AND P-TYPE METAL GATE TRANSISTORS**
INTEGRATION VON TRANSISTOREN MIT N-TYP UND P-TYP METALLGATES
INTEGRATION DE TRANSISTORS A GRILLE METALLIQUE DU TYPE N ET DU TYPE P

(30) Priority: 20.12.2002 US 327293
(43) Date of publication of application: 14.09.2005
(60) Divisional application: 12158444.5
(73) Proprietor: Intel Corporation, Santa Clara, CA 95052 (US)
(72) Inventor: DOCZY, Mark, Santa Clara, CA 95054 (US); KEATING, Steven, Beaverton, OR 97007 (US); KAVALIEROS, Jack, Portland, OR 97229 (US); DOYLE, Brian, Portland, OR 97229 (US); BARNS, Chris, Portland, OR 97229 (US); BARNAK, John, M/S:RNB4-140, Santa Clara, CA 95054 (US); MCSWINEY, Michael, Scappoose, OR 97056 (US); BRASK, Justin, Santa Clara, CA 95054 (US)
(74) Representative: Goddar, Heinz J.
(86) International application number: PCT/US2003/039914
(87) International publication number: WO 2004/061915

(56) References cited:
- EP-A- 0 899 784
- GB-A- 2 358 737
- US-A1- 2002 058 374
- US-B1- 6 255 698
- US-B1- 6 365 450

## Description

### FIELD

The invention relates to the manufacture of complementary metal-oxide-semiconductor (CMOS) devices. More particularly, the invention relales to integrating n-type and p-type metal gate transistors within a single CMOS device.

### BACKGROUND

Prior art CMOS devices manufactured with prior art semiconductor processes typically have polysilicon gate structures. Polysilicon, however, can be susceptible to depletion effects, which can add to the overall gate dielectric thickness in the CMOS device. Furthermore, as the effective physical gate dielectric thickness decreases, the polysilicon depletion contributes proportionally to the total dielectric thickness. It is, therefore, desirable to eliminate polysilicon depletion in order to scale gate oxide thickness.

Metal gates, on the other hand, are not as susceptible to depletion as polysilicon and are in many ways preferable to polysilicon for forming gate structures. Typical prior art semiconductor processes, however, do not incorporate n-type and p-type metal gates within the same device or integrated circuit. This is due, in part, to the complexity and cost of developing a semiconductor process that can reliably deposit metal gate structures of differing types into the same semiconductor device or integrated circuit.

In document GB 2 358 737 two methods for manufacturing complimentary MOSFET devices are disclosed. The first (depicted in figs 1-3) comprises depositing dummy gate electrodes on a substrate, using these as ion implantation masks and then forming an insulation film over the substrate and dummy gate electrodes. The dummy electrodes are removed separately and the recesses left in the insulation film are individually filled with different gate electrode materials. The second method (depicted in figs 5 and 6) comprises separately forms gate electrodes of different material in recesses formde in an insulation layer and then uses these actual electrodes as implantation masks. Electrode materials, insulation layer materials and composite electrodes are all disclosed. The gate electrode materials preferably have a work function close to the work function of either n or p type polysilicon.

Document US 2002/058374 A1 relates to a method of forming dual-metal gates in a semiconductor device, including the steps of providing a semiconductor substrate having a PMOS area and an NMOS area wherein dummy gates are formed in the PMOS and NMOS areas respectively, forming an insulating interlayer on the semiconductor substrate so as to cover the dummy gates, polishing the insulating interlayer until the dummy gates are exposed, forming a first groove defining a first metal gate area by selectively removing one of the dummy gates formed in the PMOS and NMOS areas, forming a first gate insulating layer and a first metal layer on an entire area of the semiconductor substrate including the first groove successively, forming a first metal gate in the first groove by etching the first metal layer and first gate insulating layer until the insulating interlayer is exposed, forming a second groove defining a second metal gate area by removing the remaining dummy gate, forming a second gate insulating layer and a second metal layer on the entire area of the semiconductor substrate including the second groove, and forming a second metal gate in the second groove by etching the second metal layer and second gate insulating layer until the insulating interlayer is exposed.

Documents US-B1-6 255 698, EP-A-0 899 789 and US-B-6 365 450 also disclose the formation of n-type and n-type transistors.

### BRIEF DESCRIPTION OF THE DRAWINGS

Embodiments of the invention are illustrated by way of example and not limitation in the figures of the accompanying drawings, in which like references indicate similar elements and in which:

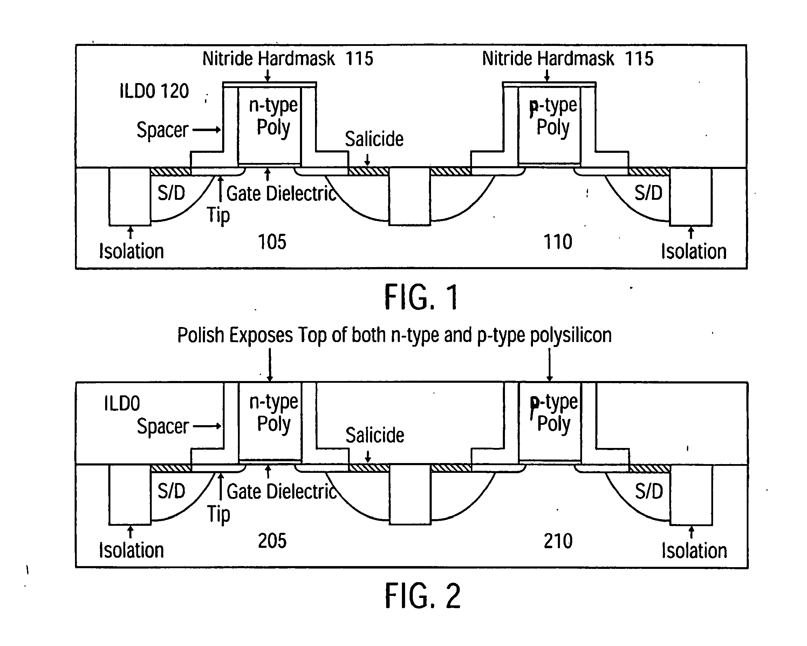

Figure 1 illustrates the state of transistors after depositing ILDO according to one embodiment.

Figure 2 illustrates the state of transistors after ILDO polish-back to expose polysilicon gate structures according to one embodiment.

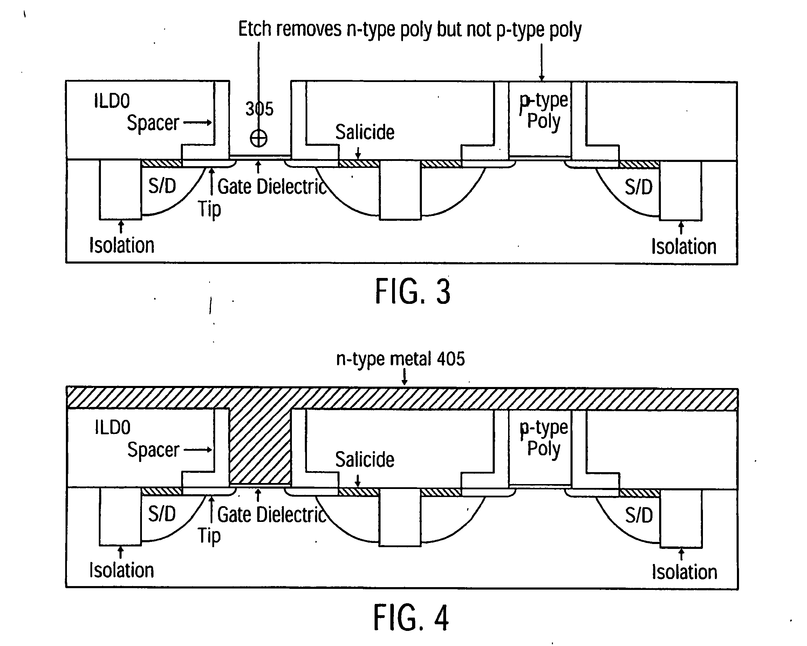

Figure 3 illustrates the state of transistors after selective n-type poly etch according to one embodiment.

Figure 4 illustrates the state of transistors after depositing n-type metal according to one embodiment.

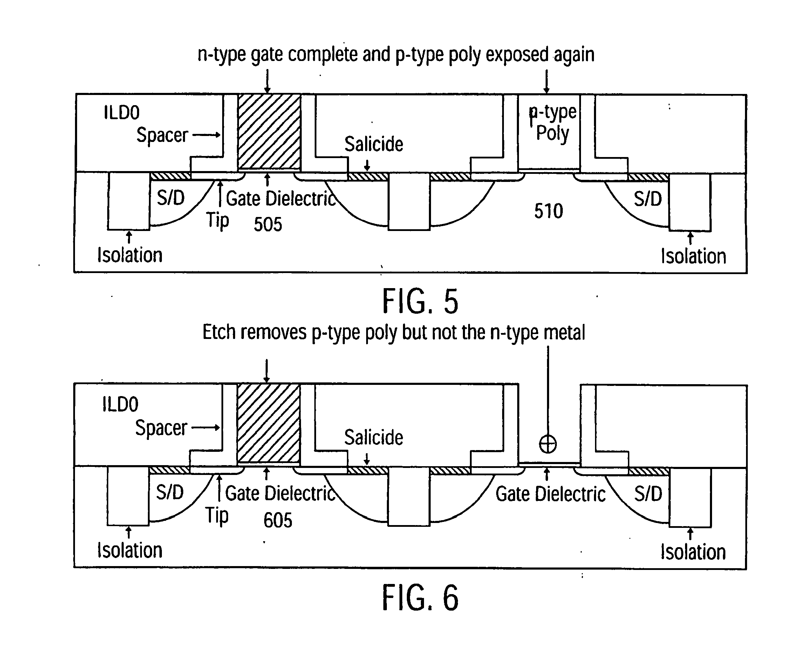

Figure 5 illustrates the state of transistors after polishing the n-type metal according to one embodiment.

Figure 6 illustrates the state of transistors after selectively etching p-type polysilicon according to one embodiment.

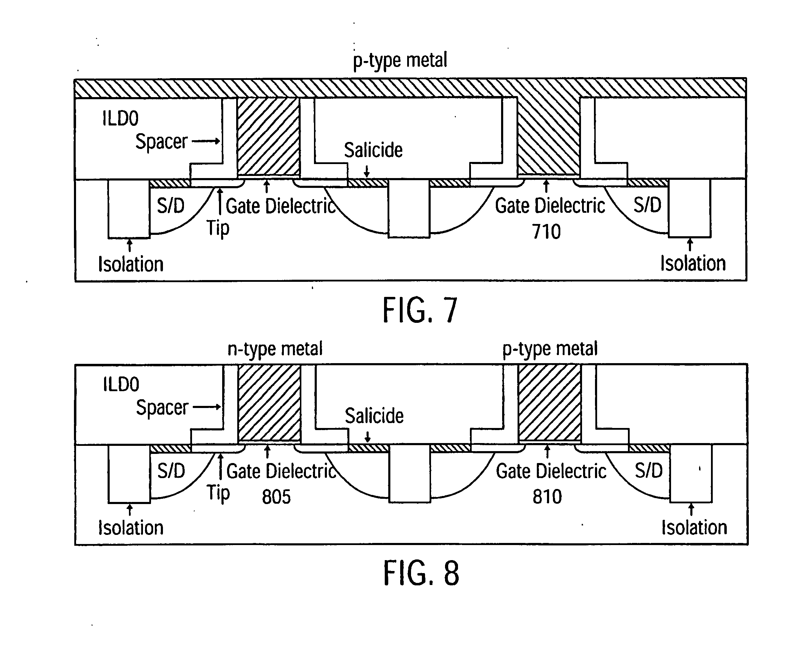

Figure 7 illustrates the state of transistors after depositing p-type metal according to one embodiment.

Figure 8 illustrates the state of transistors after polishing the p-type metal according to one embodiment.

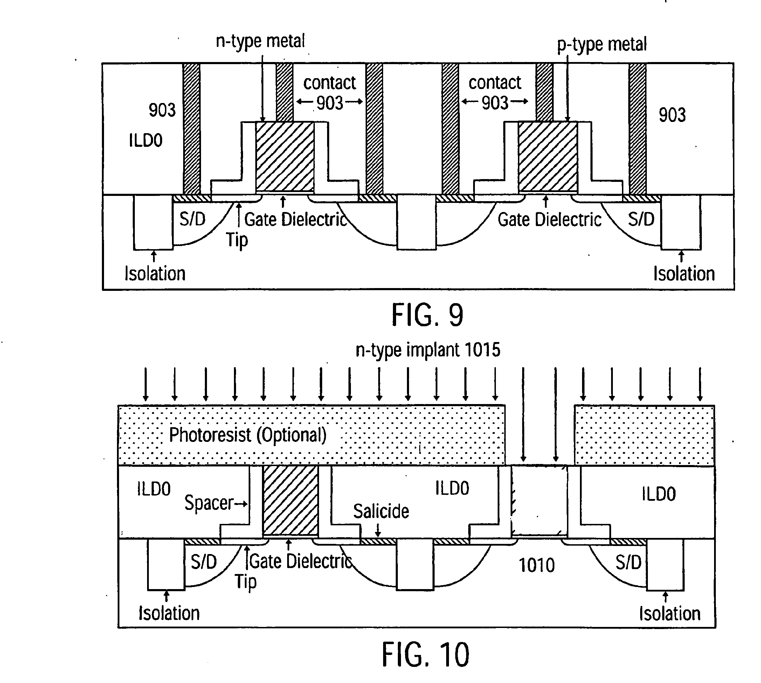

Figure 9 illustrates the completed transistors according to one embodiment.

Figure 10 illustrates the state of transistors after an optional implant patterning according to one non-claimed example.

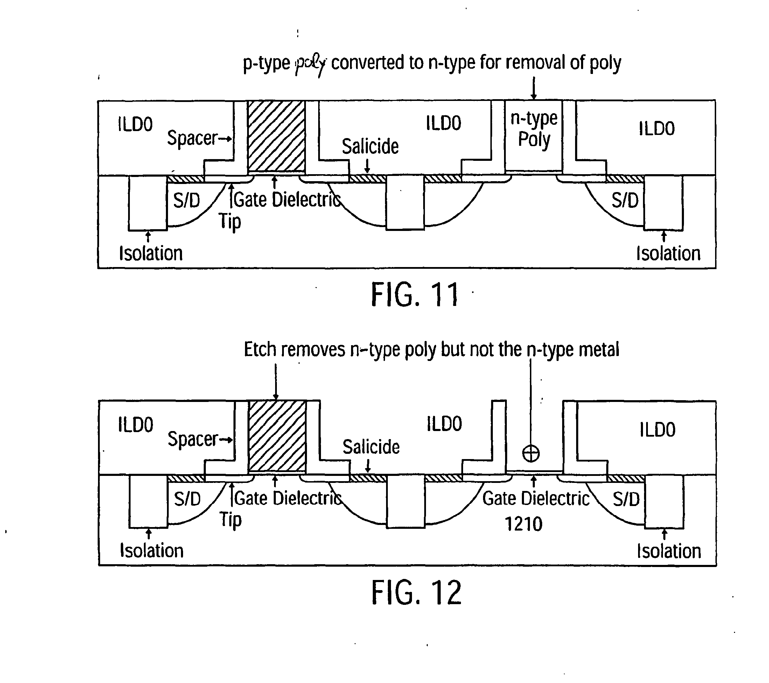

Figure 11 illustrates the state of transistors of Fig. 10 after n-type implant and ash.

Figure 12 illustrates the state of transistors of Fig. 11 after a second selective n-type polysilicon etch.

### DETAILED DESCRIPTION

Embodiments of the invention described herein relate to semiconductor manufacturing. More particularly, embodiments of the invention described relate to integrating n-type and p-type metal gate transistors within the same complementary metal-oxide-semiconductor (CMOS) device or integrated circuit.

In order to manufacture CMOS devices and integrated circuits that can avoid the effects of gate depletion, embodiments of the invention incorporate n-type and p-type metal gates into the same CMOS device or integrated circuits.

Figure 1 illustrates a cross-section of a CMOS device containing a p-type transistor and an n-type transistor after depositing ILDO ("Inter-layer dielectric") according to one embodiment. In Figure 1, poly-silicon gate transistors 105, 110 are fabricated using standard CMOS processing techniques in order to prevent silicide formation on the poly-silicon gate electrode. The nitride hard masks 115 are to protect the gate structures during silicidation and ILDO 120 is deposited on the structure.

The ILDO is polished back to expose the doped polysilicon gates in Figure 2. The ILDO polishing also removes residual silicide around the nitride masking layer. After the polysilicon gates 205, 210 are exposed, an ammonium hydroxide etch is used to selectively etch away 305 the n-type polysilicon. The ammonium hydroxide etch is low temperature (e.g., <40 deg. Celsius), uses sonication, and has a concentration of approximately 2 - 29%. The result of the polysilicon etch is illustrated in Figure 3.

Removal of the n-type polysilicon above the gate dielectric creates a damascene-like "trench" which is filled with an n-type metal 405, such as Hf, Zr, Ti, Ta, or Al, as illustrated in Figure 4. Alternatively, the trench can be filled with an alloy containing an n-type component using PVD ("Physical vapor deposition"), CVD ("Chemical vapor deposition"), or ALD ("Atomic Layer deposition"). CVD and ALD may use an organometallic or halide precursor, and a reducing atmosphere. Furthermore, the thickness of the n-type metal or alloy can be such that the trench is only partially filled. For example, the thickness of the n-type metal or alloy can vary from approximately 50 angstroms to approximately 1000 angstroms in various embodiments. If the trenches are not completely filled, they may be filled with an easily polished metal, such as W (tungsten") or Al ("Aluminum").

The n-type metal gate can be doped by implanting n-type material after the metal gate has been deposited in the trench.

The n-type metal is polished back to create the n-type metal gates 505 and to expose the p-type polysilicon gate 510 as illustrated in Figure 5.

Figure 6 illustrates the transistors after a selective dry etch is performed to remove the p-type polysilicon without removing the n-type metal gate. The selective dry etch can be performed using a parallel plate or ECR ("Electron cyclotron resonance") etcher and SF6 ("Sulfur hexafluoride"), HBr ("Hydrogen Bromide"), Hl ("Hydrogen Iodide"), Cl2 ("Chlorine"), Ar ("Argon"), and/or He ("Helium"). Alternatively, a wet etch, such as approximately 20 - 30 % TMAH ("Tetramethylammonium Hydroxide") at approximately 60 - 90 degrees Celsius with or without sonication may also be used to remove the p-type polysilicon gate.

A p-type metal, such as Ru ("Ruthenium"), Pd (palladium"), Pt ("platinum"), Co ("Cobalt'), Ni ("Nickel"), TiAlN ("Titanium Aluminum Nitride"), or WCN ("Tungsten Carbon Nitride") can be used to fill the gate trench created by etching the p-type polysilicon gate 510. Alternatively, an alloy using p-type metal can be deposited in the trench using chemical vapor deposition or atomic layer deposition with an organometallic precursor and a reducing atmosphere.
The p-type metal gate can be doped by implanting the metal gate with p-type material after the metal gate has been deposited in the gate trench.
Furthermore, the thickness of the p-type metal or alloy can be such that the trench is only partially filled. Figure 7 illustrates the transistors after the p-type metal or alloy has been deposited in the gate trench 710.

The p-type metal or alloy is polished back, as illustrated in Figure 8, to create the n-type and p-type gate structures 805, 810, and ILDO is again deposited to provide room for the contact layer.

Contacts 903 are etched and deposited, as illustrated in Figure 9, resulting in the final transistor structure.

In a non-claimed alternative, rather than using a dry etch to remove the p-type polysilicon as described above, the p-type polysilicon gate can be converted to n-type in order to allow a gentler wet etch to remove the polysilicon rather than a dry etch. For example, after the p-type polysilicon 1010 has been exposed, rather than using a selective dry etch to remove the polysilicon, an n-type implant 1015 is performed to change the doping of the polysilicon in order to allow an ammonium hydroxide etch to be performed, as illustrated in Figure 10.

The result of the implant and ash (if required) is illustrated in Figure 11. An ammonium hydroxide etch removes the remaining polysilicon gate structure 1210 resulting in the structure illustrated in Figure 12. A p-type metal or alloy may then be deposited in the trench left by removing the p-type polysilicon gate as described above.

While the invention has been described with reference to illustrative embodiments, this description is not intended to be construed in a limiting sense. Various modifications of the illustrative embodiments which are apparent to persons skilled in the art to which the invention pertains are deemed to lie within the scope of the invention as defined in the appended claims.

## Claims

1. A process of
forming an n-type and a p-type transistor within a CMOS device upon a semiconductor substrate, the process comprising forming the n-type and the p-type transistor comprising an n-type (205) and a p-type (210) polysilicon gate, respectively; removing an inter-layer dielectric (ILDO) layer from the top of the polysilicon gates to expose the polysilicon gates;
selectively etching away (305) the n-type polysilicon gate from amongst the exposed n-type and p-type polysilicon gates to form a first trench bound in part by substantially vertical lateral ide-wall spacers and a gate dielectric on the bottom of the first trench;
depositing n-type metal (405) into the first trench;
removing excess n-type metal to expose the top of the n-type metal gate and the p-type polysilicon gate;
selectively etching the p-type polysilicon gate from amongst the exposed n-type metal gate and the exposed p-type polysilicon gate to form a second trench bound in part by substantially vertical lateral side-wall spacers and a gate dielectric on the bottom of the second trench;
depositing a p-type metal gate within the second trench;
removing excess p-type metal gate material to expose the top of the n-type metal gate and of the p-type metal gate.

2. The process of claim 1 further comprising forming a further inter-layer dielectric (ILDO) layer on top of the n-type and p-type transistors after the step of removing excess p-type metal gate material.

3. The process of claim 2 further comprising forming source, gate, and drain contacts to the n-type and p-type transistors.

4. The process of claim 1 wherein the n-type metal gate is selected from a group consisting of Hf, Zr, Ti, Ta, and Al.

5. The process of claim 1 wherein the p-type metal gate is selected from a group consisting of Ru, Pd, Pt, Co, Ni, TiAIN and WCN.

6. The process of claim 1 wherein the p-type metal gate and the n-type metal gate is at least 50 and no greater than 1000 angstroms thick.

7. The process of claim 1 wherein selectively etching the n-type with respect to the p-type polysilicon gates carried out by means of an ammonium hydroxide etch.

8. The process of claim 1 wherein etching the n-type and p-type polysilicon gates is performed by using a wet etch.

9. The process of claim 1 wherein the n-type metal gate is doped by implanting n-type material after the metal gate has been deposited into the first trench.

10. The process of claim 1 wherein the p-type metal gate is doped by implanting the metal gate with p-type material after the metal gate has been deposited into the second trench.

## Patentansprüche

1. Verfahren zum Ausbilden eines n-Typ- und eines p-Typ-Transistors in einer CMOS-Vorrichtung auf einem Halbleitersubstrat, wobei das Verfahren ein Ausbilden des n-Typ- und des p-Typ-Transistors aufweist, welche ein n-Typ-(205)- bzw. ein p-Typ (210)-Polysilizium-Gate aufweisen,
Entfernen eines Zwischenschicht-Dielektrikums (ILD) von der Oberseite der Polysilizium-Gates, um die Polysilizium-Gates freizulegen;
selektives Weg-Ätzen (305) des n-Typ-Polysilizium-Gates bei den freigelegten n-Typ- und p-Typ-Polysilizium-Gates, um einen ersten Graben zu bilden, der teilweise durch im Wesentlichen vertikale seitliche Seitenwand-Spacer und ein Gate-Dielektrikum an der Unterseite des ersten Grabens begrenzt ist;
Abscheiden eines n-Typ-Metalls (405) in den ersten Graben;
Entfernen von überschüssigem n-Typ-Metall, um die Oberseite des n-Typ-Metall-Gates und des p-Typ-Polysilizium-Gates freizulegen;
selektives Ätzen des p-Typ-Polysilizium-Gates bei dem freigelegten n-Typ-Metall-Gate und dem freigelegten p-Typ-Polysilizium-Gate, um einen zweiten Graben zu bilden, der teilweise durch im Wesentlichen vertikale seitliche Seitenwand-Spacer und ein Gate-Dielektrikum auf der Unterseite des zweiten Grabens begrenzt ist;
Abscheiden eines p-Typ-Metall-Gates im zweiten Graben;
Entfernen von überschüssigem p-Typ-Metall-Gate-Material, um die Oberseite des n-Typ-Metall-Gates und des p-Typ-Metall-Gates freizulegen.

2. Verfahren nach Anspruch 1, das des Weiteren ein Ausbilden einer weiteren Zwischenschicht-Dielektrikums-Schicht (ILD) auf der Oberseite des n-Typ- und p-Typ-Transistors nach dem Schritt des Entfernens von überschüssigem p-Typ-Metall-Gate-Material aufweist.

3. Verfahren nach Anspruch 2, das des Weiteren ein Ausbilden von Source-, Gate-, und Drain-Kontakten zu den n-Typ- und p-Typ-Transistoren aufweist.

4. Verfahren nach Anspruch 1, wobei das n-Typ-Metall-Gate aus einer Gruppe ausgewählt ist bestehend aus Hf, Zr, Ti, Ta und Al.

5. Verfahren nach Anspruch 1, wobei das p-Typ-Metall-Gate aus einer Gruppe gewählt ist, bestehend aus Ru, Pd, Pt, Co, Ni, TiAlN und WCN.

6. Verfahren nach Anspruch 1, wobei das p-Typ-Metall-Gate und das n-Typ-Metall-Gate zumindest 50 Angström und nicht mehr als 1000 Angström dick ist.

7. Verfahren nach Anspruch 1, wobei das selektive Ätzen des n-Typ im Verhältnis zu den p-Typ-Polysilizium-Gates mittels einer Ammoniumhydoxid-Ätze ausgeführt wird.

8. Verfahren nach Anspruch 1, wobei das Ätzen des n-Typ- und p-Typ-Polysilizium-Gates unter Verwendung einer Nassätze durchgeführt wird.

9. Verfahren nach Anspruch 1, wobei das n-Typ-Metall-Gate durch Implantieren von n-Typ-Material dotiert wird, nachdem das Metall-Gate in den ersten Graben abgeschieden wurde.

10. Verfahren nach Anspruch 1, wobei das p-Typ-Metall-Gate durch Implantieren des Metall-Gates mit einem p-Typ-Material dotiert wird, nachdem das Metall-Gate in den zweiten Graben abgeschieden wurde.

## Revendications

1. Procédé de
formation d'un transistor de type n et d'un transistor de type p dans un dispositif CMOS sur un substrat semiconducteur, le procédé comprenant la formation du transistor de type n et du transistor de type p comprenant une grille de polysilicium de type n (209) et de type p (210), respectivement ;
ablation d'une couche inter-couche diélectrique (ILDO) depuis le dessus des grilles de polysilicium pour exposer les grilles de polysilicium ;
attaque sélective (305) de la grille de polysilicium de type n parmi les grilles de polysilicium de type n et de type p exposées pour former une première tranchée délimitée en partie par des espaceurs de paroi latérale latéraux sensiblement verticaux et un diélectrique de grille sur le fond de la première tranchée ;
dépôt de métal de type n (405) dans la première tranchée ;
ablation de l'excès de métal de type n pour exposer le haut de la grille de métal de type n et la grille de polysilicium de type p ;
attaque sélective de la grille de polysilicium de type p de la grille de métal de type n exposée et la grille de polysilicium de type p pour former une deuxième tranchée délimitée en partie par des espaceurs de paroi latérale latéraux sensiblement verticaux et une grille diélectrique au fond de la deuxième tranchée ;
dépôt d'une grille de métal de type p dans la deuxième tranchée ;
ablation de l'excès de matériau de grille de métal de type p pour exposer le haut de la grille de métal de type n et de la grille de métal de type p.

2. Procédé de la revendication 1 comprenant en outre la formation d'une couche inter-couche diélectrique (ILDO) supplémentaire au-dessus des transistors de type n et de type p après l'étape d'ablation de l'excès de matériau de grille de métal de type p.

3. Procédé de la revendication 2 comprenant en outre la formation de contacts de source, de grille, et de drain pour les transistors de type n et de type p.

4. Procédé de la revendication 1 dans lequel la grille de métal de type n est choisie dans un groupe constitué de Hf, Zr, Ti, Ta, et Al.

5. Procédé de la revendication 1 dans lequel la grille de métal de type p est choisie dans un groupe constitué de Ru, Pd, Pt, Co, Ni, TiAlN et WCN.

6. Procédé de la revendication 1 dans lequel la grille de métal de type p et la grille de métal de type n sont d'au moins 50 et de pas plus de 1000 angströms d'épaisseur.

7. Procédé de la revendication 1 dans lequel l'attaque sélective de la grille de polysilicium de type n par rapport à la grille de polysilicium de type p est conduite au moyen d'une attaque à l'hydroxyde d'ammonium.

8. Procédé de la revendication 1 dans lequel l'attaque des grilles de polysilicium de type n et de type p est effectuée en utilisant une attaque par voie humide.

9. Procédé de la revendication 1 dans lequel la grille de métal de type n est dopée par implantation de matériau de type n après que la grille de métal ait été déposée dans la première tranchée.

10. Procédé de la revendication 1 dans lequel la grille de métal de type p est dopée par implantation de la grille de métal avec un matériau de type p après que la grille de métal ait été déposée dans la deuxième tranchée.
